# EUROPEAN PATENT SPECIFICATION

(11) **EP 2 698 576 B1**
(45) Date of publication and mention of the grant of the patent: **20.09.2017**
(21) Application number: 13178125.4
(22) Date of filing: 26.07.2013
(51) Int. Cl.: F21K 99/00, F21V 9/00, H01L 33/50, F21V 9/16, H05B 33/14, F21Y 115/10

(54) **Lighting device**
Beleuchtungsvorrichtung
Dispositif d'éclairage

(30) Priority: 13.08.2012 JP 2012179390
(43) Date of publication of application: 19.02.2014
(73) Proprietor: Panasonic Intellectual Property Management Co., Ltd., Osaka-shi, Osaka 540-6207 (JP)
(72) Inventor: Takei, Naoko, Chuo-ku, Osaka 540-6207 (JP); Nishioka, Kouji, Chuo-ku, Osaka 540-6207 (JP); Nishi, Sayaka, Chuo-ku, Osaka 540-6207 (JP); Saito, Takashi, Chuo-ku, Osaka 540-6207 (JP)
(74) Representative: Appelt, Christian W.

(56) References cited:
- EP-A1- 2 560 218
- US-A1- 2007 278 930
- US-A1- 2010 277 059

## Description

The present invention relates to a lighting device.

Various types of know lighting devices, such as LED elements, put significance on high efficiency. In such a lighting device that puts significance on high efficiency, the device has an improved light emitting efficiency. However, due to low color rendering, when the light from the device reaches an object or a person, the color of the object or the skin color of the person may not be truly reproduced.

Japanese Laid-Open Patent Publication No. 2010-176992 discloses a lighting device that puts significance on high color rendering so that the color of an object and the skin color of a person may be truly reproduced. The lighting device takes into consideration, for example, a general color rendering index and special color rendering index No. 15 (R15).

The above lighting device is configured to truly reproduce the skin color of a person, that is, to have a high rendering index, by increasing the general color rendering index Ra and the special color rendering index No. 15 (R15). In addition to truly reproducing the skin color, it is desirable that a lighting device be developed so that skin is rendered with a preferable color.

US 2007/0278930 A1 discloses a light emitting device including a semiconductor light emitting element and a plurality of phosphors. Thereby, an oxanitride phosphor is used which emits a light having a wavelength of 510 nm or less.

EP 2 560 218 A1 is at most prior art under Art. 54(3) EPC only and describes an illumination device that includes an irradiation unit having a light emitting element and fluorescent bodies excited by the light from the light emitting element to radiate light of different wavelengths. The irradiation unit irradiates composite light of blue, green and red lights having half value widths of 20-40 nm, 110-150 nm and 80-110 nm and peak wavelengths of 440-465 nm, 545-555 nm and 630-650 nm, respectively. If the output value of the light in a wavelength 435-465 nm is assumed to be 100%, the output values of the lights having wavelengths of 490, 530 and 639 nm fall within 46-56%, 59-77% and 75-98%, respectively. The ratio of the output value of the light of 630 nm to that of the light of 530 nm falls within 73-86%.

It is an object of the present invention to provide a lighting device that improves the appearance of skin in a preferable manner.

A first aspect of the present invention is a lighting device provided with a lighting unit including a light emitting element and a plurality of fluorescent bodies, each emitting light of a different wavelength when excited by light from the light emitting element. Under an assumption that a peak output value of the emitted light is 100% in a range of wavelength 440 to 465 nm, the lighting unit is configured to emit light having an output value at wavelength 500 nm that is in a range from 35% to 55%, an output value at wavelength 550 nm that is in a range from 45% to 80%, an output value at wavelength 600 nm that is in a range from 45% to 75%, and an output value at wavelength 640 nm that is in a range from 50% to 80%. The lighting unit emits light having a color temperature of 4500 to 5500 K and with the output value at wavelength 640 nm in a range of 100% to 120% relative to the output value of light at wavelength 600 nm and in a range of 85% to 130% relative to the output value of light at wavelength 550 nm.

A second aspect of the present invention is a lighting device provided with a lighting unit including a light emitting element and a plurality of fluorescent bodies, each emitting light of a different wavelength when excited by light from the light emitting element. Under an assumption that a peak output value of the emitted light is 100% in a range of wavelength 440 to 465. nm, the lighting unit is configured to emit light having an output value at wavelength 500 nm that is in a range from 45% to 70%, an output value at wavelength 550 nm that is in a range from 60% to 105%, an output value at wavelength 600 nm that is in a range from 70% to 120%, and an output value at wavelength 640 nm that is in a range from 75% to 125%. The lighting unit emits light having a color temperature of 3500 to 4500 K and with the output value at wavelength 640 nm in a range of 85% to 110% relative to the output value of light at wavelength 600 nm and in a range of 95% to 135% relative to the output value of light at wavelength 550 nm.

A third aspect of the present invention is a lighting device provided with a lighting unit including a light emitting element and a plurality of fluorescent bodies, each emitting light of a different wavelength when excited by light from the light emitting element. Under an assumption that a peak output value of the emitted light is 100% in a range of wavelength 440 to 465 nm, the
lighting unit is configured to emit light having an output value at wavelength 500 nm that is in a range from 40% to 65%, an output value at wavelength 550 nm that is in a range from 60% to 125%, an output value at wavelength 600 nm that is in a range from 80% to 145%, and an output value at wavelength 640 nm that is in a range from 85% to 155%. The lighting unit emits light having a color temperature of 3000 to 4000 K and with the output value at wavelength 640 nm in a range of 100% to 120% relative to the output value of light at wavelength 600 nm and in a range of 110% to 160% relative to the output value of light at wavelength 550 nm.

A fourth aspect of the present invention is a lighting device provided with a lighting unit including a light emitting element and a plurality of fluorescent bodies, each emitting light of a different wavelength when excited by light from the light emitting element. Under an assumption that a peak output value of the emitted light is 100% in a range of wavelength 440 to 465 nm, the lighting unit is configured to emit light having an output value at wavelength 500 nm that is in a range from 45% to 80%, an output value at wavelength 550 nm that is in a range from 80% to 160%, an output value at wavelength 600 nm that is in a range from 115% to 220%, and an output value at wavelength 640 nm that is in a range from 130% to 250%. The lighting unit emits light having a color temperature of 2500 to 3500 K and with the output value at wavelength 640 nm in a range of 100% to 125% relative to the output value of light at wavelength 600 nm and in a range of 135% to 185% relative to the output value of light at wavelength 550 nm.

Other aspects and advantages of the present invention will become apparent from the following description, taken in conjunction with the accompanying drawings, illustrating by way of example the principles of the invention.

The invention, together with objects and advantages thereof, may best be understood by reference to the following description of the presently preferred embodiments together with the accompanying drawings in which:
Fig. 1 is a schematic diagram of a lighting device according to one embodiment of the present invention;
Fig. 2 is a graph showing one example of the output value characteristics of light from a lighting unit;
Fig. 3 is a chart illustrating the effects of a characteristic change for each color of light;
Fig. 4 is a chart illustrating the effects of a characteristic change for each wavelength of a combined white color;
Fig. 5 is a graph showing one example of the output value characteristics of light from the lighting unit;
Fig. 6 is a graph showing one example of the output value characteristics of light from the lighting unit;
Fig. 7 is a graph showing one example of the output value characteristics of light from the lighting unit;
Fig. 8 is a graph showing one example of the output value characteristics of light from the lighting unit; and
Fig. 9 is a chart illustrating the effects of a characteristic change for each wavelength of a combined white color.

One embodiment of the present invention will now be described with reference to the drawings.

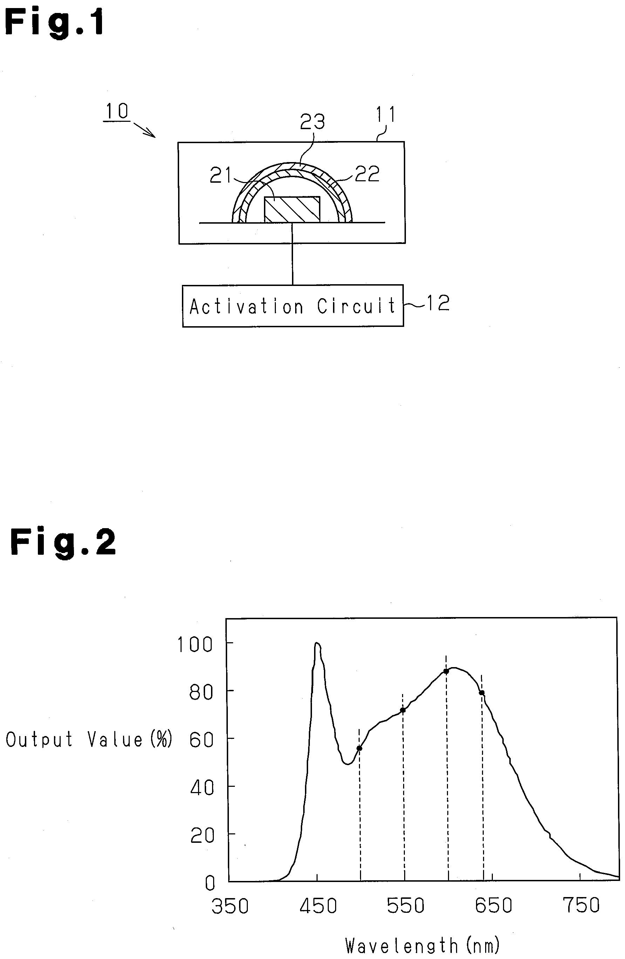

Referring to Fig. 1, a lighting device 10 of the present embodiment includes a lighting unit 11 and an activation circuit 12. The lighting unit 11 radiates light to the exterior. The activation circuit 12 activates the lighting unit 11.

As shown in Fig. 1, the lighting unit 11 includes an LED element 21, which is electrically connected to the activation circuit 12, and fluorescent bodies 22 and 23. The LED element 21 includes a light emitting surface. Each of the fluorescent bodies 22 and 23 covers the light emitting surface of the LED element and is excited by the light from the LED element 21 to radiate light having different wavelengths. When supplied with power from the activation circuit 12, the lighting unit 11 is configured to generate generally white light.

The lighting unit 11 of the lighting device 10 will now be described in detail.

To configure the lighting unit 11, the inventors of the present invention have checked (1) whether or not the light from the lighting unit 11 may be considered as having the same color as 4200 K, which is an intermediate temperature for white color, and (2) the preference index of skin color PS (proposed by Tadashi Yano) for a Japanese female as a preference index for the appearance of the skin color of a person. Specifically, the inventors of the present invention have conducted experiments A and B, which will now be described.

### Experiment A

The peak wavelength of the LED element 21, which emits blue light, and the peak wavelength and the half-value width of the fluorescent bodies 22 and 23 were changed, and it was determined whether or not the light from the lighting unit 11 was substantially the same color as light having a color shift Duv (deviation from Planckian locus) of -5 at color temperature 4200 K. The determination process is desirably performed using the 5 Standard Deviation of Color Matching (5SDCM) or 4SDMC accepted as the chromaticity tolerable range for various types of light source colors by the International Electrotechnical Commission (IEC) based on the chromaticity ellipse defined by MacAdam. However, the determination process is not particularly limited.

Further, the peak wavelength of the LED element 21, which emits blue light, and the peak wavelength and the half-value width of the fluorescent bodies 22 and 23 were changed, and the preference index of skin color PS was calculated for the light from the lighting unit 11. As disclosed in, for example, Japanese Laid-Open Patent Publication No. 11-258047, the preference index of skin color PS may be calculated by obtaining a calculation evaluation value P related to the preference of skin color and then performing the calculation of 4×5^{P}.

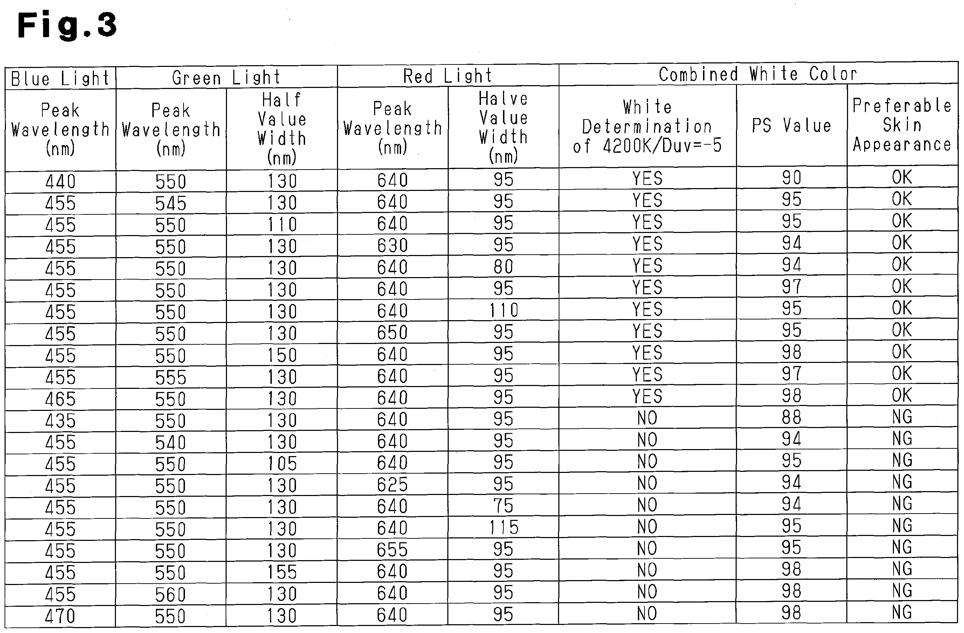

Fig. 3 shows the conditions obtained from the lighting unit 11 with light having a relatively high PS value and substantially the same color as light having a color shift Duv (deviation from Planckian locus) of -5 at color temperature 4200 K (white color). These conditions are as listed below.

### Condition A1

Blue light had a peak wavelength of 440 nm, green light had a peak wavelength of 550 nm and a half-value width of 130 nm, red light had a peak wavelength of 640 nm and a half-value width of 95 nm.

### Condition A2

Blue light had a peak wavelength of 455 nm, green light had a peak wavelength of 545 nm and a half-value width of 130 nm, red light had a peak wavelength of 640 nm and a half-value width of 95 nm.

### Condition A3

Blue light had a peak wavelength of 455 nm, green light had a peak wavelength of 550 nm and a half-value width of 110 nm, red light had a peak wavelength of 640 nm and a half-value width of 95 nm.

### Condition A4

Blue light had a peak wavelength of 455 nm, green light had a peak wavelength of 550 nm and a half-value width of 130 nm, red light had a peak wavelength of 630 nm and a half-value width of 95 nm.

### Condition A5

Blue light had a peak wavelength of 455 nm, green light had a peak wavelength of 550 nm and a half-value width of 130 nm, red light had a peak wavelength of 640 nm and a half-value width of 80 nm.

### Condition A6

Blue light had a peak wavelength of 455 nm, green light had a peak wavelength of 550 nm and a half-value width of 130 nm, red light had a peak wavelength of 640 nm and a half-value width of 95 nm.

### Condition A7

Blue light had a peak wavelength of 455 nm, green light had a peak wavelength of 550 nm and a half-value width of 130 nm, red light had a peak wavelength of 640 nm and a half-value width of 110 nm.

### Condition A8

Blue light had a peak wavelength of 455 nm, green light had a peak wavelength of 550 nm and a half-value width of 130 nm, red light had a peak wavelength of 650 nm and a half-value width of 95 nm.

### Condition A9

Blue light had a peak wavelength of 455 nm, green light had a peak wavelength of 550 nm and a half-value width of 150 nm, red light had a peak wavelength of 640 nm and a half-value width of 95 nm.

### Condition A10

Blue light had a peak wavelength of 455 nm, green light had a peak wavelength of 555 nm and a half-value width of 130 nm, red light had a peak wavelength of 640 nm and a half-value width of 95 nm.

### Condition A11

Blue light had a peak wavelength of 465 nm, green light had a peak wavelength of 550 nm and a half-value width of 130 nm, red light had a peak wavelength of 640 nm and a half-value width of 95 nm.

The following requirements may be derived from the above conditions. Blue light has a peak wavelength in the range from 440 to 465 nm. Green light has a peak wavelength in the range from 545 to 555 nm and a half-value width in the range from 110 to 150 nm. Red light has a peak wavelength in the range from 630 to 650 nm and a half-value width in the range from 80 to 110 nm.

### Experiment B

The output value (light intensity) of each of three wavelengths in the light from the lighting unit 11 including the LED element 21 and the fluorescent bodies 22 and 23 were changed, and it was determined whether or not the light from the lighting unit 11 was substantially the same color as light having a color shift Duv (deviation from Planckian locus) of -5 at color temperature 4200 K. Further, the output value of each of three wavelengths in the light from the lighting unit 11 including the LED element 21 and the fluorescent bodies 22 and 23 were changed, and the preference index of skin color PS was calculated for the light from the lighting unit 11.

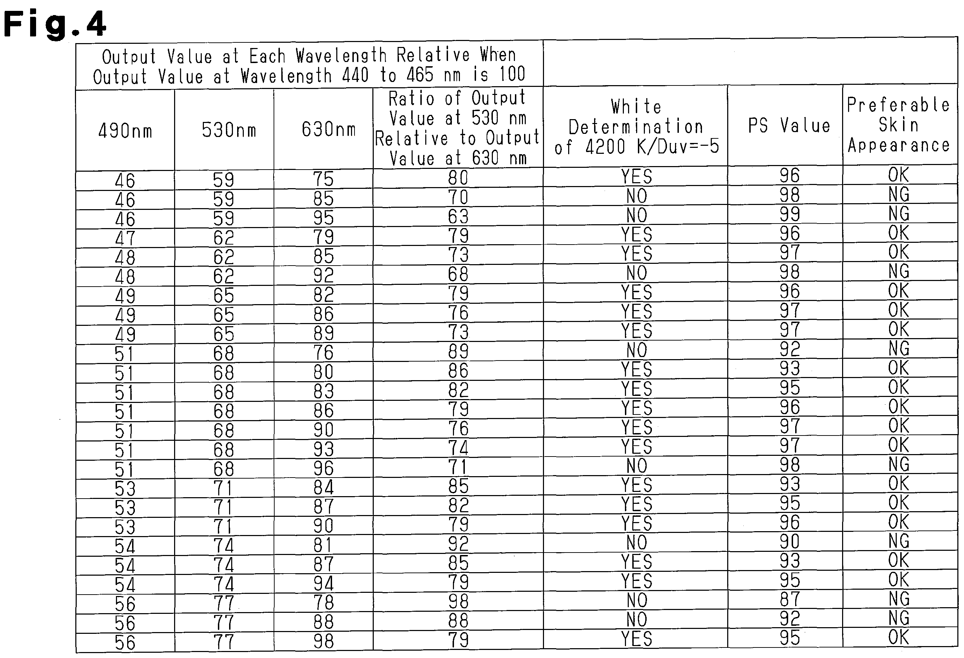

Fig. 4 shows the conditions obtained from the lighting unit 11 with light having a relatively high PS value and substantially the same color as light having a color shift Duv (deviation from Planckian locus) of -5 at color temperature 4200 K (white color). These conditions are as listed below. The three wavelengths include the wavelengths of 490 nm, 530 nm, and 630 nm. The output value of each wavelength is expressed by a rate assuming that the output value of the blue light is 100% for the wavelengths from 440 to 465 nm.

### Condition B1

The output value at wavelength 490 nm was 46%, the output value at wavelength 530 nm was 59%, the output value at wavelength 630 nm was 75%, and the ratio of the output value at wavelength 530 nm to the output value at wavelength 630 nm was 80%.

### Condition B2

The output value at wavelength 490 nm was 47%, the output value at wavelength 530 nm was 62%, the output value at wavelength 630 nm was 79%, and the ratio of the output value at wavelength 530 nm to the output value at wavelength 630 nm was 79%.

### Condition B3

The output value at wavelength 490 nm was 48%, the output value at wavelength 530 nm was 62%, the output value at wavelength 630 nm was 85%, and the ratio of the output value at wavelength 530 nm to the output value at wavelength 630 nm was 73%.

### Condition B4

The output value at wavelength 490 nm was 49%, the output value at wavelength 530 nm was 65%, the output value at wavelength 630 nm was 82%, and the ratio of the output value at wavelength 530 nm to the output value at wavelength 630 nm was 79%.

### Condition B5

The output value at wavelength 490 nm was 49%, the output value at wavelength 530 nm was 65%, the output value at wavelength 630 nm was 86%, and the ratio of the output value at wavelength 530 nm to the output value at wavelength 630 nm was 76%.

### Condition B6

The output value at wavelength 490 nm was 49%, the output value at wavelength 530 nm was 65%, the output value at wavelength 630 nm was 89%, and the ratio of the output value at wavelength 530 nm to the output value at wavelength 630 nm was 73%.

### Condition B7

The output value at wavelength 490 nm was 51%, the output value at wavelength 530 nm was 68%, the output value at wavelength 630 nm was 80%, and the ratio of the output value at wavelength 530 nm to the output value at wavelength 630 nm was 86%.

### Condition B8

The output value at wavelength 490 nm was 51%, the output value at wavelength 530 nm was 68%, the output value at wavelength 630 nm was 83%, and the ratio of the output value at wavelength 530 nm to the output value at wavelength 630 nm was 82%.

### Condition B9

The output value at wavelength 490 nm was 51%, the output value at wavelength 530 nm was 68%, the output value at wavelength 630 nm was 86%, and the ratio of the output value at wavelength 530 nm to the output value at wavelength 630 nm was 79%.

### Condition B10

The output value at wavelength 490 nm was 51%, the output value at wavelength 530 nm was 68%, the output value at wavelength 630 nm was 90%, and the ratio of the output value at wavelength 530 nm to the output value at wavelength 630 nm was 76%.

### Condition B11

The output value at wavelength 490 nm was 51%, the output value at wavelength 530 nm was 68%, the output value at wavelength 630 nm was 93%, and the ratio of the output value at wavelength 530 nm to the output value at wavelength 630 nm was 74%.

### Condition B12

The output value at wavelength 490 nm was 53%, the output value at wavelength 530 nm was 71 %, the output value at wavelength 630 nm was 84%, and the ratio of the output value at wavelength 530 nm to the output value at wavelength 630 nm was 85%.

### Condition B13

The output value at wavelength 490 nm was 53%, the output value at wavelength 530 nm was 71 %, the output value at wavelength 630 nm was 87%, and the ratio of the output value at wavelength 530 nm to the output value at wavelength 630 nm was 82%.

### Condition B14

The output value at wavelength 490 nm was 53%, the output value at wavelength 530 nm was 71 %, the output value at wavelength 630 nm was 90%, and the ratio of the output value at wavelength 530 nm to the output value at wavelength 630 nm was 79%.

### Condition B15

The output value at wavelength 490 nm was 54%, the output value at wavelength 530 nm was 74%, the output value at wavelength 630 nm was 87%, and the ratio of the output value at wavelength 530 nm to the output value at wavelength 630 nm was 85%.

### Condition B16

The output value at wavelength 490 nm was 54%, the output value at wavelength 530 nm was 74%, the output value at wavelength 630 nm was 94% and the ratio of the output value at wavelength 530 nm to the output value at wavelength 630 nm was 79%.

### Condition B17

The output value at wavelength 490 nm was 56%, the output value at wavelength 530 nm was 77%, the output value at wavelength 630 nm was 98% and the ratio of the output value at wavelength 530 nm to the output value at wavelength 630 nm was 79%.

Under conditions B1 to B17, the lighting unit 11 satisfied each of the next conditions.

### Common Condition

Under the assumption that the peak output value (intensity) of the emitted light is 100% in the range from wavelength 440 nm to 465 nm, the output value of the light at wavelength 500 nm was in the range from 45% to 70%, the output value of the light at wavelength 550 nm was in the range of 60% to 105%, the output value of the light at wavelength 600 nm was in the range of 70% to 120%, and the output value of the light at wavelength 640 nm was in the range from 75% to 125%. Further, the output value of the light at wavelength 640 nm relative to the output value of the light at wavelength 600 nm was 85% to 110%, and the output value of the light at wavelength 640 nm relative to the output value of the light at wavelength 550 nm was 95% to 135%.

In the present embodiment, the lighting unit 11 is configured to have, for example, the output characteristics shown in Fig. 2 based on the requirements derived from experiment A and experiment B.

More specifically, the LED element 21 of the lighting unit 11 emits blue light having a light emission center wavelength (peak wavelength) at 455 nm and a half value width of 30 nm. Further, in the lighting unit 11, the fluorescent body 22 receives light from the LED element 21 and emits green light, and the fluorescent body 23 receives light from the LED element 21 and emits red light. The fluorescent body 22 includes CaSc₂O₄:Ce (calcium scandate-cerium additive) that emits green light having a peak wavelength at 550 nm a half value width of 130 nm. The fluorescent body 23 includes a mixture of CaAlSiN₃:Eu (calcium aluminum silicon nitride-europium additive) and (Sr,Ca)AlSiN₃:Eu (strontium calcium aluminum silicon nitride-europium additive) that emits red light having a peak wavelength at 640 nm and a half value width of 95 nm.

The fluorescent body 22 that emits green light and the fluorescent body 23 that emits red light are mixed to obtain a ratio by weight of 100 to 23 and dispersed in silicon resin before being molded integrally.

Under the assumption that the output value of the blue light having a peak wavelength at 455 nm is 100%, the lighting unit 11 including the LED element 21 and the fluorescent bodies 22 and 23 is configured to emit light having an output value that is approximately 55% at wavelength 500 nm, approximately 70% at wavelength 550 nm, approximately 87% at wavelength 600 nm, and approximately 78% at wavelength 640 nm. The lighting unit 11 is configured to emit light having an output value at wavelength 640 nm that is approximately 90%, which is in the range from 85% to 110%, relative to the output value of the light at wavelength length 600 nm, and approximately 111%, which is in the range from 95% to 135%, relative to the output value of the light at wavelength length 550 nm.

An example of the operation of the lighting device 10 in the present embodiment will now be described.

In the lighting device 10 of the present embodiment, blue light is emitted from the LED element 21 of the lighting unit 11 by the activation circuit 12. Some of the light is absorbed by the fluorescent bodies 22 and 23, which emit light having longer wavelengths (red light or green light). Further, the lighting unit 11 combines the blue light, green light, and red light to emit white light having a color shift Duv of -5 at a color temperature of approximately 4200 K. Here, the preference of skin color PS for the emitted light is 95.

The present embodiment has the advantages described below.
(1) The lighting device 10 includes the LED element 21 and the fluorescent bodies 22 and 23. The LED element 21 emits blue light having a peak wavelength at 455 nm and a half value width of 30 nm. The fluorescent body 22 is excited by the light from the LED element 21 and emits light having a peak wavelength at 550 nm and a half value width of 130 nm. The fluorescent body 23 is excited by the light from the LED element 21 and emits light having a peak wavelength at 640 nm and a half value width of 95 nm. Further, under the assumption that the output value of the blue light having a peak wavelength at 455 nm is 100%, the lighting unit 11 is configured to emit light having an output value that is approximately 55% at wavelength 500 nm, approximately 70% at wavelength 550 nm, approximately 87% at wavelength 600 nm, and approximately 78% at wavelength 640 nm. The lighting unit 11 is configured to emit light at wavelength 640 nm having an output value that is approximately 90%, which is in the range from 85% to 110%, relative to the output value of the light at wavelength length 600 nm, and approximately 111%, which is in the range from 95% to 135%, relative to the output value of the light at wavelength length 550 nm. This configuration realizes light having a color shift Duv of -5 at a color temperature of approximately 4200 K and a preference of skin color PS of 95. Thus, with a warm white light source, which is often used in commercial facilities or the like, the skin color of a person may have a preferable appearance. By showing the skin with a preferable appearance, a female would appear more beautiful and a person would appear healthier. This would make everyone feel good and happy. When using the lighting device 10 for a studio or a stage, the skin color of a person in the studio or on the stage would have a further preferable appearance and enable further beautiful photographs to be taken.
(2) The fluorescent body 22 that emits green light includes CaSc₂O₄:Ce (calcium scandate-cerium additive) and resists temporal changes resulting from the environmental load (temperature and humidity). Thus, the durability of the fluorescent body 22 may be increased, while allowing for a stable preferable skin appearance.
(3) The fluorescent body 23 that emits red light includes a mixture of CaAlSiN₃:Eu (calcium aluminum silicon nitride-europium additive) and (Sr,Ca)AlSiN₃:Eu (strontium calcium aluminum silicon nitride-europium additive). In this case, CaAlSiN₃:Eu (calcium aluminum silicon nitride-europium additive) and (Sr,Ca)AlSiN₃:Eu (strontium calcium aluminum silicon nitride-europium additive) resist temporal changes resulting from the environmental load (temperature and humidity). The use of such materials increases the durability of the fluorescent body 23, while allowing for a stable preferable skin appearance.
(4) The fluorescent body 22 and the fluorescent body 23 are combined so that the weight of the fluorescent body 23, which emits red light, relative to the weight of the fluorescent body 22, which emits green light is 23%. This stably realizes the highly efficient lighting device 10 that emits light having a color temperature of 4200 K, a color shift Duv of -5, and a preference index of skin color PS of 95.
(5) The use of the LED element 21 lowers energy consumption as compared with when using a fluorescent lamp or an incandescent bulb as the light source.

It should be apparent to those skilled in the art that the present invention may be embodied in many other specific forms. Particularly, it should be understood that the present invention may be embodied in the following forms.

In the above embodiment, the lighting unit 11 is configured so that the color temperature of the emitted light is approximately 4200 K. However, there is no such limitation.

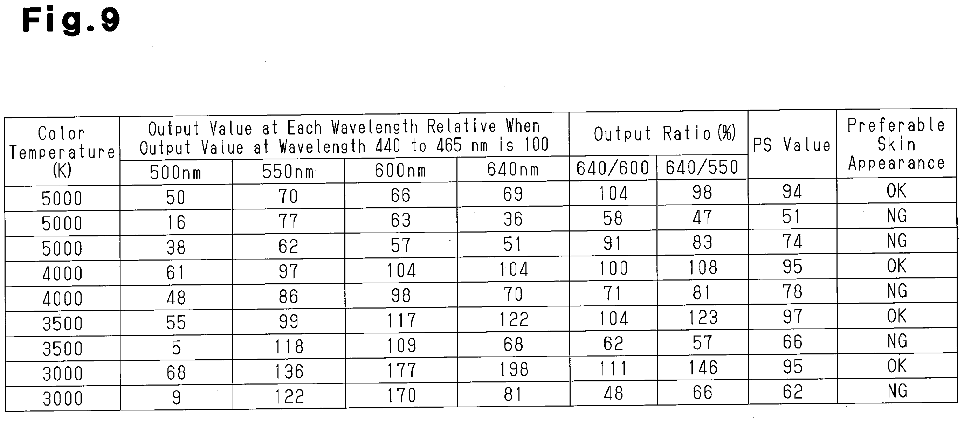

For example, when the lighting unit 11 emits light having a color temperature of 4500 to 5500 K, light having the median value of 5000 K may be used. As shown in Fig. 9, the conditions and comparative examples for this case will now be described.

### Condition C1

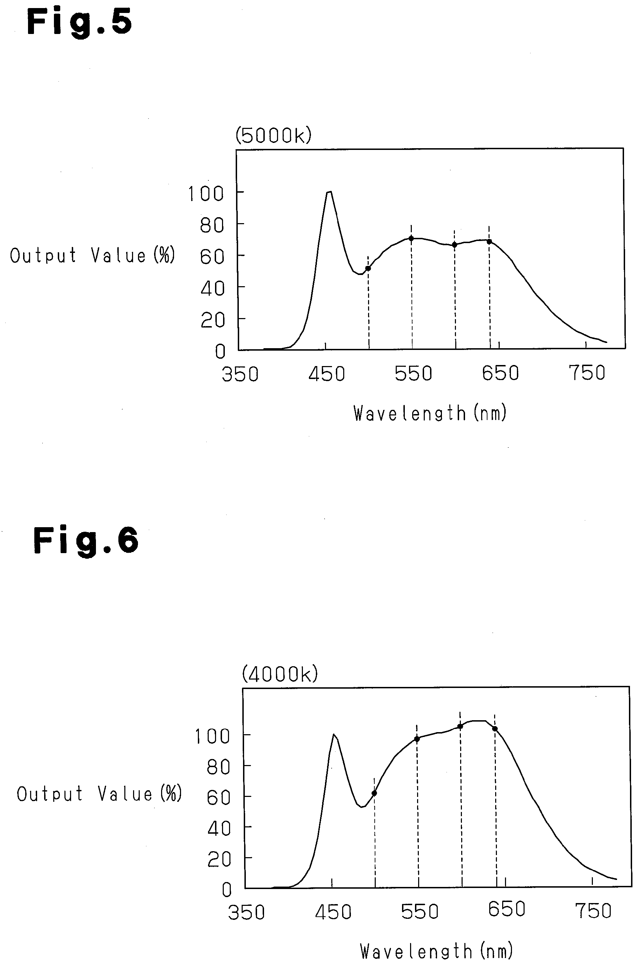

Under the assumption that the peak output value of the emitted light was 100% in the range of wavelength 440 to 465 nm, the output value of the light at wavelength 500 nm was 50%, and the output value of the light at wavelength 550 nm was 70%. Under the assumption that the peak output value of the emitted light was 100% in the range of wavelength 440 to 465 nm, the output value of the light at wavelength 600 nm was 66%, and the output value of the light at wavelength 640 nm was 69%. Further, the output value of the light at wavelength 640 nm relative to the output value of the light at wavelength 600 nm was 104%, and the output value of the light at wavelength 640 nm relative to the output value of the light at wavelength 550 nm was 98%. Fig. 5 shows the spectral distribution.

### Comparative Example C2

Under the assumption that the peak output value of the emitted light was 100% in the range of wavelength 440 to 465 nm, the output value of the light at wavelength 500 nm was 16%, and the output value of the light at wavelength 550 nm was 77%. Under the assumption that the peak output value of the emitted light was 100% in the range of wavelength 440 to 465 nm, the output value of the light at wavelength 600 nm was 63%, and the output value of the light at wavelength 640 nm was 36%. Further, the output value of the light at wavelength 640 nm relative to the output value of the light at wavelength 600 nm was 58%, and the output value of the light at wavelength 640 nm relative to the output value of the light at wavelength 550 nm was 47%.

### Comparative Example C3

Under the assumption that the peak output value of the emitted light was 100% in the range of wavelength 440 to 465 nm, the output value of the light at wavelength 500 nm was 38%, and the output value of the light at wavelength 550 nm was 62%. Under the assumption that the peak output value of the emitted light was 100% in the range of wavelength 440 to 465 nm, the output value of the light at wavelength 600 nm was 57%, and the output value of the light at wavelength 640 nm was 51 %. Further, the output value of the light at wavelength 640 nm relative to the output value of the light at wavelength 600 nm was 91 %, and the output value of the light at wavelength 640 nm relative to the output value of the light at wavelength 550 nm was 83%.

The preference index of skin color PS was 94 and high under condition C1 as compared with comparison examples C2 and C3. Accordingly, it may be determined that the appearance of skin is preferable. Further, based on condition C1 and comparative examples C2 and C3, when outputting light having a color temperature of 4500 to 5500 K, the preferable conditions are as described below.

Under the assumption that the peak output value of the emitted light is 100% in the range of wavelength 440 to 465 nm, the lighting unit 11 is configured so that the output value of the emitted light at wavelength 500 nm is in the range from 35% to 55%, and the output value of the light at wavelength 550 nm is in the range from 45% to 80%. Further, under the assumption that the peak output value of the emitted light is 100% in the range from wavelength 440 to 465 nm, the output value of the emitted light at wavelength 600 nm is in the range of 45% to 75%, and the output value of the emitted light at wavelength 640 nm is in the range from 50% to 80%. The lighting unit 11 is configured so that the output value of the light at wavelength 640 nm relative to the output value of the light at wavelength 600 nm is in the range from 100% to 120%, and the output value of the light at wavelength 640 nm relative to the output value of the light at wavelength 550 nm is in the range from 85% to 130%.

When the lighting unit 11 emits light having a color temperature of 3500 to 4500 K, light having the median value of 4000 K may be used. This configuration includes the above embodiment. As shown in Fig. 9, the conditions and comparative examples for this case will now be described.

### Condition D1

Under the assumption that the peak output value of the emitted light was 100% in the range of wavelength 440 to 465 nm, the output value of the light at wavelength 500 nm was 61%, and the output value of the light at wavelength 550 nm was 97%. Under the assumption that the peak output value of the emitted light was 100% in the range of wavelength 440 to 465 nm, the output value of the light at wavelength 600 nm was 104%, and the output value of the light at wavelength 640 nm was 104%. Further, the output value of the light at wavelength 640 nm relative to the output value of the light at wavelength 600 nm was 100%, and the output value of the light at wavelength 640 nm relative to the output value of the light at wavelength 550 nm was 108%. Fig. 6 shows the spectral distribution.

### Comparative Example D2

Under the assumption that the peak output value of the emitted light was 100% in the range of wavelength 440 to 465 nm, the output value of the light at wavelength 500 nm was 48%, and the output value of the light at wavelength 550 nm was 86%. Under the assumption that the peak output value of the emitted light was 100% in the range of wavelength 440 to 465 nm, the output value of the light at wavelength 600 nm was 98%, and the output value of the light at wavelength 640 nm was 70%. Further, the output value of the light at wavelength 640 nm relative to the output value of the light at wavelength 600 nm was 71 %, and the output value of the light at wavelength 640 nm relative to the output value of the light at wavelength 550 nm was 81%.

The preference index of skin color PS was 95 and high under condition D1 as compared with comparison example D2. Accordingly, it may be determined that the appearance of skin is preferable. Further, based on condition D1 and comparative example D2, when outputting light having a color temperature of 3500 to 4500 K, the preferable conditions are as described below.

Under the assumption that the peak output value of the emitted light is 100% in the range of wavelength 440 to 465 nm, the lighting unit 11 is configured so that the output value of the emitted light at wavelength 500 nm is in the range from 45% to 70%, and the output value of the light at wavelength 550 nm is in the range from 60% to 105%. Further, under the assumption that the peak output value of the emitted light is 100% in the range from wavelength 440 to 465 nm, the output value of the emitted light at wavelength 600 nm is in the range of 70% to 120%, and the output value of the emitted light at wavelength 640 nm is in the range from 75% to 125%. The lighting unit 11 is configured so that the output value of the light at wavelength 640 nm relative to the output value of the light at wavelength 600 nm is in the range from 85% to 110%, and the output value of the light at wavelength 640 nm relative to the output value of the light at wavelength 550 nm is in the range from 95% to 135%.

When the lighting unit 11 emits light having a color temperature of 3000 to 4000 K, light having the median value of 3500 K may be used. As shown in Fig. 9, the conditions and comparative examples for this case will now be described.

### Condition E1

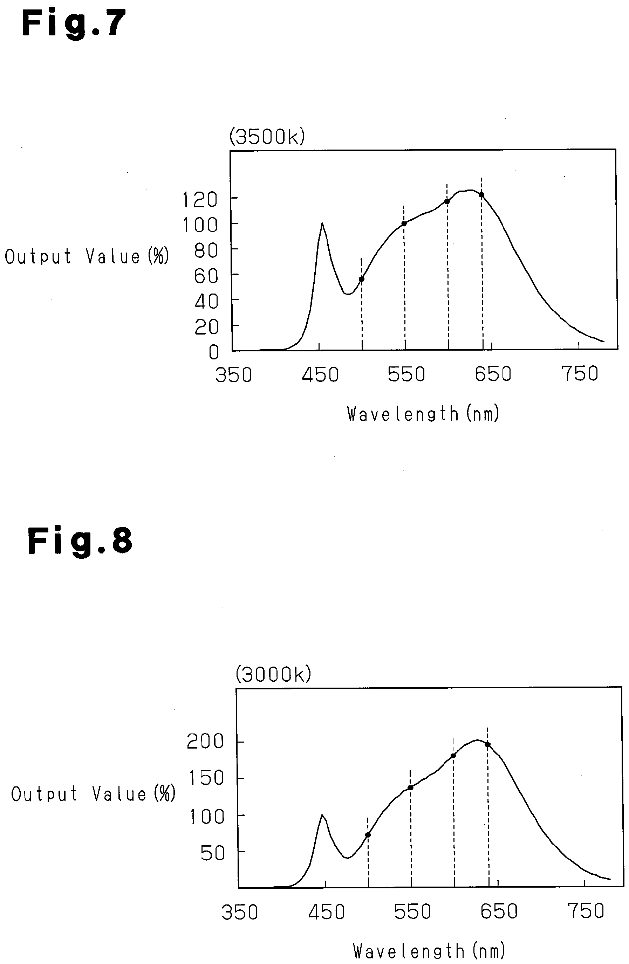

Under the assumption that the peak output value of the emitted light was 100% in the range of wavelength 440 to 465 nm, the output value of the light at wavelength 500 nm was 55%, and the output value of the light at wavelength 550 nm was 99%. Under the assumption that the peak output value of the emitted light was 100% in the range of wavelength 440 to 465 nm, the output value of the light at wavelength 600 nm was 117%, and the output value of the light at wavelength 640 nm was 122%. Further, the output value of the light at wavelength 640 nm relative to the output value of the light at wavelength 600 nm was 104%, and the output value of the light at wavelength 640 nm relative to the output value of the light at wavelength 550 nm was 123%. Fig. 7 shows the spectral distribution.

### Comparative Example E2

Under the assumption that the peak output value of the emitted light was 100% in the range of wavelength 440 to 465 nm, the output value of the light at wavelength 500 nm was 5%, and the output value of the light at wavelength 550 nm was 118%. Under the assumption that the peak output value of the emitted light was 100% in the range of wavelength 440 to 465 nm, the output value of the light at wavelength 600 nm was 109%, and the output value of the light at wavelength 640 nm was 68%. Further, the output value of the light at wavelength 640 nm relative to the output value of the light at wavelength 600 nm was 62%, and the output value of the light at wavelength 640 nm relative to the output value of the light at wavelength 550 nm was 57%.

When assuming that the output value of the light at the emission peak in the range of wavelength 440 to 465 nm is 100%, the preference index of skin color PS was 97 and high under condition E1 as compared with comparison example E2. Accordingly, it may be determined that the appearance of skin is preferable. Further, based on condition E1 and comparative example E2, when outputting light having a color temperature of 3000 to 4000 K, the preferable conditions are as described below.

Under the assumption that the peak output value of the emitted light is 100% in the range of wavelength 440 to 465 nm, the lighting unit 11 is configured so that the output value of the emitted light at wavelength 500 nm is in the range from 40% to 65%, and the output value of the light at wavelength 550 nm is in the range from 60% to 125%. Further, under the assumption that the peak output value of the emitted light is 100% in the range from wavelength 440 to 465 nm, the output value of the emitted light at wavelength 600 nm is in the range of 80% to 145%, and the output value of the emitted light at wavelength 640 nm is in the range from 85% to 155%. The lighting unit 11 is configured so that the output value of the light at wavelength 640 nm relative to the output value of the light at wavelength 600 nm is in the range from 100% to 120%, and the output value of the light at wavelength 640 nm relative to the output value of the light at wavelength 550 nm is in the range from 110% to 160%.

When the lighting unit 11 emits light having a color temperature of 3000 to 4000 K, light having the median value of 3500 K may be used. As shown in Fig. 9, the conditions and comparative examples for this case will now be described.

### Condition F1

Under the assumption that the peak output value of the emitted light was 100% in the range of wavelength 440 to 465 nm, the output value of the light at wavelength 500 nm was 68%, and the output value of the light at wavelength 550 nm was 136%. Under the assumption that the peak output value of the emitted light was 100% in the range of wavelength 440 to 465 nm, the output value of the light at wavelength 600 nm was 177%, and the output value of the light at wavelength 640 nm was 198%. Further, the output value of the light at wavelength 640 nm relative to the output value of the light at wavelength 600 nm was 111%, and the output value of the light at wavelength 640 nm relative to the output value of the light at wavelength 550 nm was 146%. Fig. 8 shows the spectral distribution.

### Comparative Example F2

Under the assumption that the peak output value of the emitted light was 100% in the range of wavelength 440 to 465 nm, the output value of the light at wavelength 500 nm was 9%, and the output value of the light at wavelength 550 nm was 122%. Under the assumption that the peak output value of the emitted light was 100% in the range of wavelength 440 to 465 nm, the output value of the light at wavelength 600 nm was 170%, and the output value of the light at wavelength 640 nm was 81 %. Further, the output value of the light at wavelength 640 nm relative to the output value of the light at wavelength 600 nm was 48%, and the output value of the light at wavelength 640 nm relative to the output value of the light at wavelength 550 nm was 66%.

The preference index of skin color PS was 95 and high under condition F1 as compared with comparison example F2. Accordingly, it may be determined that the appearance of skin is preferable. Further, based on condition F1 and comparative example F2, when outputting light having a color temperature of 2500 to 3500 K, the preferable conditions are as described below.

Under the assumption that the peak output value of the emitted light is 100% in the range of wavelength 440 to 465 nm, the lighting unit 11 is configured so that the output value of the emitted light at wavelength 500 nm is in the range from 45% to 80%, and the output value of the light at wavelength 550 nm is in the range from 80% to 160%. Further, under the assumption that the peak output value of the emitted light is 100% in the range from wavelength 440 to 465 nm, the output value of the emitted light at wavelength 600 nm is in the range of 115% to 220%, and the output value of the emitted light at wavelength 640 nm is in the range from 130% to 250%. The lighting unit 11 is configured so that the output value of the light at wavelength 640 nm relative to the output value of the light at wavelength 600 nm is in the range from 100% to 125%, and the output value of the light at wavelength 640 nm relative to the output value of the light at wavelength 550 nm is in the range from 135% to 185%.

In the above embodiment, the LED element 21 is configured to emit light having a peak wavelength at 455 nm and a half value width of 30 nm. However, the LED element 21 only needs to emit light having a peak wavelength in the range from 440 to 465 nm and a half value width in the range from 20 to 40 nm. Preferably, the LED element 21 is configured to emit light having a peak wavelength in the range from 445 to 460 nm.

In the above embodiment, the fluorescent body 22 that emits green light is configured to emit light having a peak wavelength at 550 nm and a half value width of 130 nm. However, the fluorescent body 22 only needs to emit light having a peak wavelength in the range from 545 to 555 nm and a half value width in the range from 110 to 150 nm. Preferably, the fluorescent body 22 is configured to emit light having a peak wavelength in the range from 547 to 553 nm and a half value width in the range from 120 to 140 nm.

In the above embodiment, the fluorescent body 23 that emits red light is configured to emit light having a peak wavelength at 640 nm and a half value width of 95 nm. However, the fluorescent body 23 only needs to emit light having a peak wavelength in the range from 630 to 650 nm and a half value width in the range from 80 to 110 nm. Preferably, the fluorescent body 23 is configured to emit light having a peak wavelength in the range from 635 to 645 nm and a half value width in the range from 80 to 110 nm.

In the above embodiment, the fluorescent body 22 that radiates green light includes calcium scandate-cerium additive. Instead, the fluorescent body 22 may be, for example, a silicate-europium additive fluorescent body, a silicate-cerium additive fluorescent body, an aluminate-cerium additive fluorescent body, a scandate-cerium additive fluorescent body, an oxynitride-europium additive fluorescent body, or a thiogallate-europium additive fluorescent body.

In the above embodiment, the fluorescent body 23 that radiates red light includes a mixture of calcium aluminum silicon nitride-europium additive and strontium calcium aluminum silicon nitride-europium additive. Instead, the fluorescent body 23 may be, for example, a nitride-europium additive fluorescent body, an oxynitride-europium additive fluorescent body, a sulfide-europium additive fluorescent body, a silicate-europium additive fluorescent body, or at least one of calcium aluminum silicon nitride-europium additive and strontium calcium aluminum silicon nitride-europium additive.

In the above embodiment, the fluorescent body 22 and the fluorescent body 23 are combined so that the weight of the fluorescent body 23, which emits red light, relative to the weight of the fluorescent body 22, which emits green light is 23%. Instead, the fluorescent body 22 and the fluorescent body 23 may be combined so that the weight of the fluorescent body 23 relative to the weight of the fluorescent body 22 is in a range from 20% to 27%.

In the above embodiment, under the assumption that the peak output value of the emitted light at 455 nm is 100%, the lighting unit 11 is configured to emit light so that the output value at wavelength 490 nm is 51%, the output value at wavelength 530 nm is 68%, and the output value at wavelength 630 nm is 86%. However, the lighting unit 11 only needs to be configured to emit light so that when assuming that the peak output value of the emitted light is 100% in the range of wavelength 440 to 465 nm, the output value at wavelength 490 nm is in the range from 45% to 57%, the output value at wavelength 530 nm is in the range from 58% to 78%, and the output value at wavelength 630 nm is in the range from 75% to 100%. Further, the lighting unit 11 may be configured to emit light having an output value at wavelength 630 nm in a range from 72% to 87% relative to an output value of light at wavelength 530 nm.

In the above embodiment, the light emitting element includes the LED element 21. Instead, the light emitting element may include another light emitting element such as an organic electroluminescence (EL) element.

Technical concepts that may be recognized from the above embodiment will now be described.
(a) The lighting device according to claim 2, wherein
   the lighting unit emits light combining blue light having a peak wavelength in a range from 440 to 465 nm and a half value width in a range of 20 to 40 nm, green light having a peak wavelength in a range from 545 to 555 nm and a half value width in a range of 110 to 150 nm, and red light having a peak wavelength in a range from 630 to 650 nm and a half value width in a range of 80 to 110 nm; and
   under an assumption that a peak output value of light is 100% in a range of wavelength 440 to 465 nm, the light emitted from the lighting unit has an output value at wavelength 490 nm in a range from 45% to 57%, an output value at wavelength 530 nm in a range from 58% to 78%, an output value at wavelength 630 nm in a range from 75% to 100%, and the output value at wavelength 630 nm relative to the output value at wavelength 530 nm is in a range from 72% to 87%.
(b) The lighting device according to concept (a), wherein
   the light emitting element is an LED element emitting blue light having a peak wavelength in a range from 440 to 465 nm and a half value width in a range of 20 to 40 nm; and
   the fluorescent bodies include a fluorescent body that emits green light having a peak wavelength in a range from 545 to 555 nm and a half value width in a range of 110 to 150 nm, and a fluorescent body that emits red light having a peak wavelength in a range from 630 to 650 nm and a half value width in a range from 80 to 110 nm.
(c) The lighting device according to concept (b), wherein the fluorescent body that emits the green light includes calcium scandate-cerium additive.
(d) The lighting device according to concept (b) or (c), wherein the fluorescent body that emits the red light includes at least one of calcium aluminum silicon nitride-europium additive and strontium calcium aluminum silicon nitride-europium additive.
(e) The lighting device according to any one of concepts (b) to (d), wherein under an assumption that the fluorescent body that emits the green light has a weight of 100%, the fluorescent body that emits the red light has a weight in a range from 20% to 27%.

The present examples and embodiments are to be considered as illustrative and not restrictive, and the invention is not to be limited to the details given herein.

## Claims

1. A lighting device (10), comprising
a lighting unit (11) including
a light emitting element (21), and
a plurality of fluorescent bodies (22, 23), each emitting light of a different wavelength when excited by light from the light emitting element (21), **characterized in that**
under an assumption that a peak output value of the emitted light is 100% in a range of wavelength 440 to 465 nm, the lighting unit (11) is configured to emit light having an output value at wavelength 500 nm that is in a range from 35% to 55%, an output value at wavelength 550 nm that is in a range from 45% to 80%, an output value at wavelength 600 nm that is in a range from 45% to 75%, and an output value at wavelength 640 nm that is in a range from 50% to 80%, and
the lighting unit (11) emits light having a color temperature of 4500 to 5500 K and with the output value at wavelength 640 nm in a range of 100% to 120% relative to the output value of light at wavelength 600 nm and in a range of 85% to 130% relative to the output value of light at wavelength 550 nm.

2. A lighting device (10), comprising
a lighting unit (11) including
a light emitting element (21), and
a plurality of fluorescent bodies (22, 23), each emitting light of a different wavelength when excited by light from the light emitting element (21), **characterized in that**
under an assumption that a peak output value of the emitted light is 100% in a range of wavelength 440 to 465 nm, the lighting unit (11) is configured to emit light having an output value at wavelength 500 nm that is in a range from 45% to 70%, an output value at wavelength 550 nm that is in a range from 60% to 105%, an output value at wavelength 600 nm that is in a range from 70% to 120%, and an output value at wavelength 640 nm that is in a range from 75% to 125%, and the lighting unit (11) emits light having a color temperature of 3500 to 4500 K and with the output value at wavelength 640 nm in a range of 85% to 110% relative to the output value of light at wavelength 600 nm and in a range of 95% to 135% relative to the output value of light at wavelength 550 nm.

3. A lighting device (10), comprising
a lighting unit (11) including
a light emitting element (21), and
a plurality of fluorescent bodies (22, 23), each emitting light of a different wavelength when excited by light from the light emitting element (21), **characterized in that**
under an assumption that a peak output value of the emitted light is 100% in a range of wavelength 440 to 465 nm, the lighting unit (11) is configured to emit light having an output value at wavelength 500 nm that is in a range from 40% to 65%, an output value at wavelength 550 nm that is in a range from 60% to 125%, an output value at wavelength 600 nm that is in a range from 80% to 145%, and an output value at wavelength 640 nm that is in a range from 85% to 155%, and the lighting unit (11) emits light having a color temperature of 3000 to 4000 K and with the output value at wavelength 640 nm in a range of 100% to 120% relative to the output value of light at wavelength 600 nm and in a range of 110% to 160% relative to the output value of light at wavelength 550 nm.

4. A lighting device (10), comprising
a lighting unit (11) including
a light emitting element (21), and
a plurality of fluorescent bodies (22, 23), each emitting light of a different wavelength when excited by light from the light emitting element (21), **characterized in that**
under an assumption that a peak output value of the emitted light is 100% in a range of wavelength 440 to 465 nm, the lighting unit (11) is configured to emit light having an output value at wavelength 500 nm that is in a range from 45% to 80%, an output value at wavelength 550 nm that is in a range from 80% to 160%, an output value at wavelength 600 nm that is in a range from 115% to 220%, and an output value at wavelength 640 nm that is in a range from 130% to 250%, and the lighting unit (11) emits light having a color temperature of 2500 to 3500 K and with the output value at wavelength 640 nm in a range of 100% to 125% relative to the output value of light at wavelength 600 nm and in a range of 135% to 185% relative to the output value of light at wavelength 550 nm.

5. The lighting device (10) according to any one of claims 1 to 4, **characterized in that** the light emitting element (21) includes an LED element that emits blue light having a peak wavelength in a range from 440 to 465 nm and a half width value in a range from 20 to 40 nm.

6. The lighting device (10) according to any one of claims 1 to 5, **characterized in that** the fluorescent bodies (22, 23) includes
a fluorescent body (22) that emits green light when excited by light from the light emitting element, wherein the green light has a peak wavelength in a range from 545 to 555 nm and a half value width in a range from 110 to 150 nm, and
a fluorescent body (23) that emits red light when excited by light from the light emitting element, wherein the red light has a peak wavelength in a range from 630 to 650 nm and a half value width in a range from 80 to 110 nm.

7. The lighting device according to claim 6, **characterized in that** the fluorescent body (22) that emits green light includes calcium scandate-cerium additive.

8. The lighting device according to claim 6 or 7, **characterized in that** the fluorescent body (23) that emits red light includes a mixture of calcium aluminum silicon nitride-europium additive and strontium calcium aluminum silicon nitride-europium additive.

9. The lighting device according to any one of claims 6 to 8, **characterized in that** under an assumption that weight of the fluorescent body (22) that emits green light is 100%, weight of the fluorescent body (23) that emits red light is in a range from 20% to 27%.

## Patentansprüche

1. Beleuchtungsvorrichtung (10), die Folgendes umfasst:
eine Beleuchtungseinheit (11), die Folgendes enthält ein lichtemittierendes Element (21) und
mehrere Leuchtstoffkörper (22, 23), welcher jeder Licht einer verschiedenen Wellenlänge emittiert, wenn er durch Licht aus dem lichtemittierenden Element (21) erregt wird,
**dadurch gekennzeichnet, dass**
unter einer Annahme, dass ein Spitzenausgabewert des emittierten Lichts zu 100 % in einem Wellenlängenbereich von 440 bis 465 nm liegt, die Beleuchtungseinheit (11) konfiguriert ist, Licht mit einem Ausgabewert bei 500 nm Wellenlänge, welcher in einem Bereich von 35 % bis 55 % liegt, mit einem Ausgabewert bei 550 nm Wellenlänge, welcher in einem Bereich von 45 % bis 80 % liegt, mit einem Ausgabewert bei 600 nm Wellenlänge, welcher in einem Bereich von 45 % bis 75 % liegt, und mit einem Ausgabewert bei 640 nm Wellenlänge zu emittieren, welcher in einem Bereich von 50 % bis 80 % liegt, und die Beleuchtungseinheit (11) Licht mit einer Farbtemperatur von 4500 bis 5500 K und mit dem Ausgabewert bei 640 nm Wellenlänge in einem Bereich von 100 % bis 120 % in Bezug auf den Ausgabewert von Licht bei 600 nm Wellenlänge und in einem Bereich von 85 % bis 130 % in Bezug auf den Ausgabewert von Licht bei 550 nm Wellenlänge emittiert.

2. Beleuchtungsvorrichtung (10), die Folgendes umfasst:
eine Beleuchtungseinheit (11), die Folgendes enthält
ein lichtemittierendes Element (21) und
mehrere Leuchtstoffkörper (22, 23), welcher jeder Licht einer verschiedenen Wellenlänge emittiert, wenn er durch Licht aus dem lichtemittierenden Element (21) erregt wird,
**dadurch gekennzeichnet, dass**
unter einer Annahme, dass ein Spitzenausgabewert des emittierten Lichts zu 100 % in einem Wellenlängenbereich von 440 bis 465 nm liegt, die Beleuchtungseinheit (11) konfiguriert ist, Licht mit einem Ausgabewert bei 500 nm Wellenlänge, welcher in einem Bereich von 45 % bis 70 % liegt, mit einem Ausgabewert bei 550 nm Wellenlänge, welcher in einem Bereich von 60 % bis 105 % liegt, mit einem Ausgabewert bei 600 nm Wellenlänge, welcher in einem Bereich von 70 % bis 120 % liegt, und mit einem Ausgabewert bei 640 nm Wellenlänge zu emittieren, welcher in einem Bereich von 75 % bis 125 % liegt, und die Beleuchtungseinheit (11) Licht mit einer Farbtemperatur von 3500 bis 4500 K und mit dem Ausgabewert bei 640 nm Wellenlänge in einem Bereich von 85 % bis 110 % in Bezug auf den Ausgabewert von Licht bei 600 nm Wellenlänge und in einem Bereich von 95 % bis 135 % in Bezug auf den Ausgabewert von Licht bei 550 nm Wellenlänge emittiert.

3. Beleuchtungsvorrichtung (10), die Folgendes umfasst:
eine Beleuchtungseinheit (11), die Folgendes enthält ein lichtemittierendes Element (21) und
mehrere Leuchtstoffkörper (22, 23), welcher jeder Licht einer verschiedenen Wellenlänge emittiert, wenn er durch Licht aus dem lichtemittierenden Element (21) erregt wird,
**dadurch gekennzeichnet, dass**
unter einer Annahme, dass ein Spitzenausgabewert des emittierten Lichts zu 100 % in einem Wellenlängenbereich von 440 bis 465 nm liegt, die Beleuchtungseinheit (11) konfiguriert ist, Licht mit einem Ausgabewert bei 500 nm Wellenlänge, welcher in einem Bereich von 40 % bis 65 % liegt, mit einem Ausgabewert bei 550 nm Wellenlänge, welcher in einem Bereich von 60 % bis 125 % liegt, mit einem Ausgabewert bei 600 nm Wellenlänge, welcher in einem Bereich von 80 % bis 145 % liegt, und mit einem Ausgabewert bei 640 nm Wellenlänge zu emittieren, welcher in einem Bereich von 85 % bis 155 % liegt, und die Beleuchtungseinheit (11) Licht mit einer Farbtemperatur von 3000 bis 4000 K und mit dem Ausgabewert bei 640 nm Wellenlänge in einem Bereich von 100 % bis 120 % in Bezug auf den Ausgabewert von Licht bei 600 nm Wellenlänge und in einem Bereich von 110 % bis 160 % in Bezug auf den Ausgabewert von Licht bei 550 nm Wellenlänge emittiert.

4. Beleuchtungsvorrichtung (10), die Folgendes umfasst:
eine Beleuchtungseinheit (11), die Folgendes enthält ein lichtemittierendes Element (21) und
mehrere Leuchtstoffkörper (22, 23), welcher jeder Licht einer verschiedenen Wellenlänge emittiert, wenn er durch Licht aus dem lichtemittierenden Element (21) erregt wird,
**dadurch gekennzeichnet, dass**
unter einer Annahme, dass ein Spitzenausgabewert des emittierten Lichts zu 100 % in einem Wellenlängenbereich von 440 bis 465 nm liegt, die Beleuchtungseinheit (11) konfiguriert ist, Licht mit einem Ausgabewert bei 500 nm Wellenlänge, welcher in einem Bereich von 45 % bis 80 % liegt, mit einem Ausgabewert bei 550 nm Wellenlänge, welcher in einem Bereich von 80 % bis 160 % liegt, mit einem Ausgabewert bei 600 nm Wellenlänge, welcher in einem Bereich von 115 % bis 220 % liegt, und mit einem Ausgabewert bei 640 nm Wellenlänge zu emittieren, welcher in einem Bereich von 130 % bis 250 % liegt, und die Beleuchtungseinheit (11) Licht mit einer Farbtemperatur von 2500 bis 3500 K und mit dem Ausgabewert bei 640 nm Wellenlänge in einem Bereich von 100 % bis 125 % in Bezug auf den Ausgabewert von Licht bei 600 nm Wellenlänge und in einem Bereich von 135 % bis 185 % in Bezug auf den Ausgabewert von Licht bei 550 nm Wellenlänge emittiert.

5. Beleuchtungsvorrichtung (10) nach einem der Ansprüche 1 bis 4, **dadurch gekennzeichnet, dass** das lichtemittierende Element (21) ein LED-Element umfasst, welches blaues Licht mit einer Spitzenwertwellenlänge in einem Bereich von 440 bis 465 nm und mit einem Halbhöhenbreitenwert in einem Bereich von 20 bis 40 nm emittiert.

6. Beleuchtungssteuerungsvorrichtung (10) nach einem der Ansprüche 1 bis 5, **dadurch gekennzeichnet, dass** die Leuchtstoffkörper (22, 23) Folgendes umfassen
einen Leuchtstoffkörper (22), welcher grünes Licht emittiert, wenn er durch Licht aus dem lichtemittierenden Element erregt wird, wobei das grüne Licht eine Spitzenwertwellenlänge in einem Bereich von 545 bis 555 nm und einen Halbhöhenbreitenwert in einem Bereich von 110 bis 150 nm aufweist, und
einen Leuchtstoffkörper (23), welcher rotes Licht emittiert, wenn er durch Licht aus dem lichtemittierenden Element erregt wird, wobei das rote Licht eine Spitzenwertwellenlänge in einem Bereich von 630 bis 650 nm und einen Halbhöhenbreitenwert in einem Bereich von 80 bis 110 nm aufweist.

7. Beleuchtungsvorrichtung nach Anspruch 6, **dadurch gekennzeichnet, dass** der Leuchtstoffkörper (22), welcher grünes Licht emittiert, einen Calciumscandat-Cer-Zusatz umfasst.

8. Beleuchtungsvorrichtung nach Anspruch 6 oder 7, **dadurch gekennzeichnet, dass** der Leuchtstoffkörper (23), welcher rotes Licht emittiert, eine Mischung aus einem Calciumaluminiumsiliziumnitrid-Europium-Zusatz und aus einem Strontiumcalciumaluminiumsiliziumnitrid-Europium-Zusatz umfasst.

9. Beleuchtungsvorrichtung nach einem der Ansprüche 6 bis 8, **dadurch gekennzeichnet, dass** unter einer Annahme, dass eine Masse des Leuchtstoffkörpers (22), welcher grünes Licht emittiert, 100 % ist, eine Masse des Leuchtstoffkörpers (23), welcher rotes Licht emittiert, in einem Bereich von 20 % bis 27 % liegt.

## Revendications

1. Dispositif d'éclairage (10), comprenant
une unité d'éclairage (11) comprenant
un élément électroluminescent (21), et
une pluralité de corps fluorescents (22, 23), chacun émettant une lumière d'une longueur d'onde différente lorsqu'il est excité par une lumière provenant de l'élément électroluminescent (21),
**caractérisé en ce que**
sur la base d'une hypothèse selon laquelle une valeur de crête de sortie de la lumière émise est de 100 % dans une plage de longueur d'onde de 440 à 465 nm, l'unité d'éclairage (11) est configurée pour émettre une lumière ayant une valeur de sortie à une longueur d'onde de 500 nm qui est dans une plage de 35 % à 55 %, une valeur de sortie à une longueur d'onde de 550 nm qui est dans une plage de 45 % à 80 %, une valeur de sortie à une longueur d'onde de 600 nm qui est dans une plage de 45 % à 75 %, et une valeur de sortie à une longueur d'onde de 640 nm qui est dans une plage de 50 % à 80 %, et l'unité d'éclairage (11) émet une lumière ayant une température de couleur de 4500 à 5500 K et avec la valeur de sortie à une longueur d'onde de 640 nm dans une plage de 100 % à 120 % par rapport à la valeur de sortie de lumière à une longueur d'onde de 600 nm et dans une plage de 85 % à 130 % par rapport à la valeur de sortie de lumière à une longueur d'onde de 550 nm.

2. Dispositif d'éclairage (10), comprenant
une unité d'éclairage (11) comprenant
un élément électroluminescent (21), et
une pluralité de corps fluorescents (22, 23), chacun émettant une lumière d'une longueur d'onde différente lorsqu'il est excité par une lumière provenant de l'élément électroluminescent (21),
**caractérisé en ce que**
sur la base d'une hypothèse selon laquelle une valeur de crête de sortie de la lumière émise est de 100 % dans une plage de longueur d'onde de 440 à 465 nm, l'unité d'éclairage (11) est configurée pour émettre une lumière ayant une valeur de sortie à une longueur d'onde de 500 nm qui est dans une plage de 45 % à 70 %, une valeur de sortie à une longueur d'onde de 550 nm qui est dans une plage de 60 % à 105 %, une valeur de sortie à une longueur d'onde de 600 nm qui est dans une plage de 70 % à 120 %, et une valeur de sortie à une longueur d'onde de 640 nm qui est dans une plage de 75 % à 125 %, et l'unité d'éclairage (11) émet une lumière ayant une température de couleur de 3500 à 4500 K et avec la valeur de sortie à une longueur d'onde de 640 nm dans une plage de 85 % à 110 % par rapport à la valeur de sortie de lumière à une longueur d'onde de 600 nm et dans une plage de 95 % à 135 % par rapport à la valeur de sortie de lumière à une longueur d'onde de 550 nm.

3. Dispositif d'éclairage (10), comprenant
une unité d'éclairage (11) comprenant
un élément électroluminescent (21), et
une pluralité de corps fluorescents (22, 23), chacun émettant une lumière d'une longueur d'onde différente lorsqu'il est excité par une lumière provenant de l'élément électroluminescent (21),
**caractérisé en ce que**
sur la base d'une hypothèse selon laquelle une valeur de crête de sortie de la lumière émise est de 100 % dans une plage de longueur d'onde de 440 à 465 nm, l'unité d'éclairage (11) est configurée pour émettre une lumière ayant une valeur de sortie à une longueur d'onde de 500 nm qui est dans une plage de 40 % à 65 %, une valeur de sortie à une longueur d'onde de 550 nm qui est dans une plage de 60 % à 125 %, une valeur de sortie à une longueur d'onde de 600 nm qui est dans une plage de 80 % à 145 %, et une valeur de sortie à une longueur d'onde de 640 nm qui est dans une plage de 85 % à 155 %, et l'unité d'éclairage (11) émet une lumière ayant une température de couleur de 3000 à 4000 K et avec la valeur de sortie à une longueur d'onde de 640 nm dans une plage de 100 % à 120 % par rapport à la valeur de sortie de lumière à une longueur d'onde de 600 nm et dans une plage de 110 % à 160 % par rapport à la valeur de sortie de lumière à une longueur d'onde de 550 nm.

4. Dispositif d'éclairage (10), comprenant
une unité d'éclairage (11) comprenant
un élément électroluminescent (21), et
une pluralité de corps fluorescents (22, 23), chacun émettant une lumière d'une longueur d'onde différente lorsqu'il est excité par une lumière provenant de l'élément électroluminescent (21), **caractérisé en ce que**
sur la base d'une hypothèse selon laquelle une valeur de crête de sortie de la lumière émise est de 100 % dans une plage de longueur d'onde de 440 à 465 nm, l'unité d'éclairage (11) est configurée pour émettre une lumière ayant une valeur de sortie à une longueur d'onde de 500 nm qui est dans une plage de 45 % à 80 %, une valeur de sortie à une longueur d'onde de 550 nm qui est dans une plage de 80 % à 160 %, une valeur de sortie à une longueur d'onde de 600 nm qui est dans une plage de 115 % à 220 %, et une valeur de sortie à une longueur d'onde de 640 nm qui est dans une plage de 130 % à 250 %, et l'unité d'éclairage (11) émet une lumière ayant une température de couleur de 2500 à 3500 K et avec la valeur de sortie à une longueur d'onde de 640 nm dans une plage de 100 % à 125 % par rapport à la valeur de sortie de lumière à une longueur d'onde de 600 nm et dans une plage de 135 % à 185 % par rapport à la valeur de sortie de lumière à une longueur d'onde de 550 nm.

5. Dispositif d'éclairage (10) selon l'une quelconque des revendications 1 à 4, **caractérisé en ce que** l'élément électroluminescent (21) comprend un élément LED qui émet une lumière bleue ayant une longueur d'onde de crête dans une plage de 440 à 465 nm et une valeur de largeur à mi-hauteur dans une plage de 20 à 40 nm.

6. Dispositif d'éclairage (10) selon l'une quelconque des revendications 1 à 5, **caractérisé en ce que** les corps fluorescents (22, 23) comprennent
un corps fluorescent (22) qui émet une lumière verte lorsqu'il est excité par une lumière provenant de l'élément électroluminescent, la lumière verte ayant une longueur d'onde de crête dans une plage de 545 à 555 nm et une valeur de largeur à mi-hauteur dans une plage de 110 à 150 nm, et un corps fluorescent (23) qui émet une lumière rouge lorsqu'il est excité par une lumière provenant de l'élément électroluminescent, la lumière rouge ayant une longueur d'onde de crête dans une plage de 630 à 650 nm et une valeur de largeur à mi-hauteur dans une plage de 80 à 110 nm.

7. Dispositif d'éclairage selon la revendication 6, **caractérisé en ce que** le corps fluorescent (22) qui émet une lumière verte comprend un additif de scandate de calcium-cérium.

8. Dispositif d'éclairage selon la revendication 6 ou 7, **caractérisé en ce que** le corps fluorescent (23) qui émet une lumière rouge comprend un mélange d'additif de calcium-aluminium-nitrure de silicium-europium et un additif de strontium-calcium-aluminium-nitrure de silicium-europium.

9. Dispositif d'éclairage selon l'une quelconque des revendications 6 à 8,
**caractérisé en ce que**, sur la base de l'hypothèse selon laquelle le poids du corps fluorescent (22) qui émet une lumière verte est 100 %, le poids du corps fluorescent (23) qui émet une lumière rouge est dans une plage de 20 % à 27 %.
